# EUROPEAN PATENT SPECIFICATION

(11) **EP 2 518 763 B1**
(45) Date of publication and mention of the grant of the patent: **09.09.2015**
(21) Application number: 12165448.7
(22) Date of filing: 25.04.2012
(51) Int. Cl.: H01L 21/677, H01L 21/687, C23C 16/458, C23C 16/509, H01J 37/32, H01L 21/67

(54) **A grounding assembly for vacuum processing apparatus**
Erdungsvorrichtung für Vakuumverarbeitungsvorrichtung
Dispositif de mise à la terre pour un appareil de traitement sous vide

(30) Priority: 25.04.2011 US 201113093698
(43) Date of publication of application: 31.10.2012
(73) Proprietor: Orbotech LT Solar, LLC, San Jose, California 95119 (US)
(72) Inventor: Stevens, Craig Lyle, Ben Lomond, CA 95005 (US); Blonigan, Wendell Thomas, Pleasanton, CA 94566 (US)
(74) Representative: Puschmann Borchert Bardehle Patentanwälte Partnerschaft mbB

(56) References cited:
- WO-A2-2010/091205
- US-A1- 2010 136 261

## Description

The invention concerns a vacuum processing apparatus, such as plasma chambers used for etching or forming thin films on substrates or other workpieces.

Manufacturing processes in the fields of semiconductor, flat panel displays, solar panels, etc., involve processing in vacuum chambers. For example, vacuum chambers are used for plasma-enhanced chemical vapor deposition (PECVD), physical vapor deposition (PVD), plasma etching and various other processes for forming thin films on substrates (workpieces) and etching structures on the substrates. In such chambers, various gases are flowed into the chamber, either via injectors or via a showerhead and plasma is ignited to etch or deposit thin film on the substrate. In order to attract charged species in the plasma towards the substrate, a ground potential is applied to the substrate or to an electrode under the substrate.

US 2010/136261 (A1) discloses a method and apparatus for processing substrates using plasma. More particularly, embodiments of the present invention provide a plasma processing chamber having an electrode coupled to a plurality of RF returning straps, wherein impedance of the RF returning straps are set and/or adjusted to tune the plasma distribution during processing. In one embodiment, impedance of RF returning straps varies by changing length of the RF returning straps, by changing width of the RF returning straps, by changing spacing of the RF returning straps, by changing location of the RF returning straps, by adding a capacitor to the RF returning straps, or by combinations thereof.

WO2010091205 (A2) discloses a method and an apparatus for providing an electrically symmetrical ground or return path for electrical current between two electrodes is described. The apparatus includes at least on radio frequency (RF) device coupled to one of the electrodes and between a sidewall and/or a bottom of a processing chamber. The method includes moving one electrode relative to another and realizing a ground return path based on the position of the displaced electrode using one or both of a RF device coupled to a sidewall and the electrode, a RF device coupled to a bottom of the chamber and the electrode, or a combination thereof.

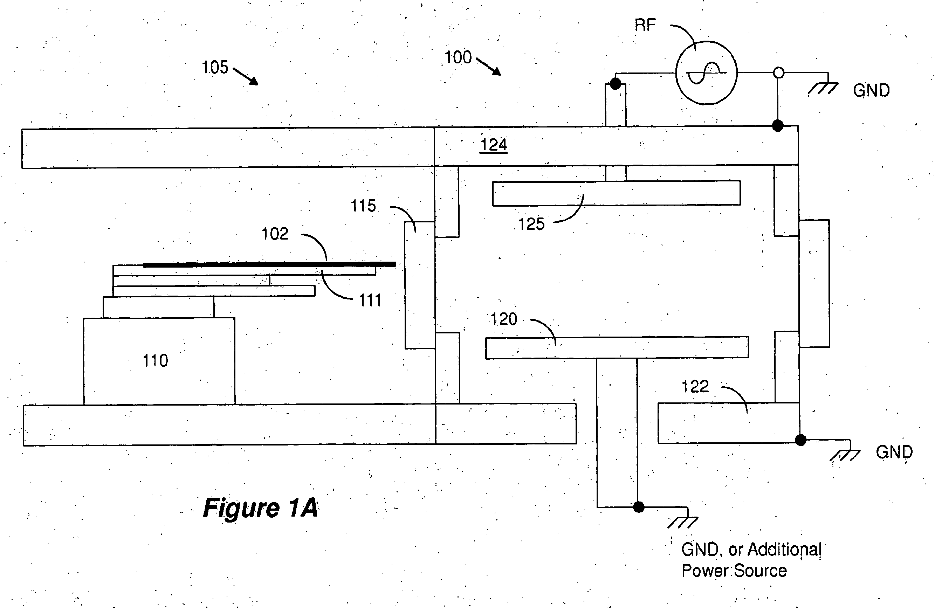

Figs. 1A-1C are schematics of various stages of a vacuum processing chamber for processing one single substrate at a time, in which embodiments of the invention may-be implemented. Loading chamber 105 is used to bad single substrate 102 into vacuum processing chamber 100. In Fig.1A, the vacuum door 115 is closed, and the substrate is positioned on the articulated arm 111 of robot 110 in the loading chamber 105. As shown, the lower electrode 120, the chamber's body 122 and the chamber's ceiling 124 are all grounded. In this example, RF power is coupled to the upper electrode 125 while ground or other power is provided to the lower electrode 120. However, it is also known to couple ground to the upper electrode and supply RF power to the lower electrode or supply RF power to both the electrodes in a grounded chamber.

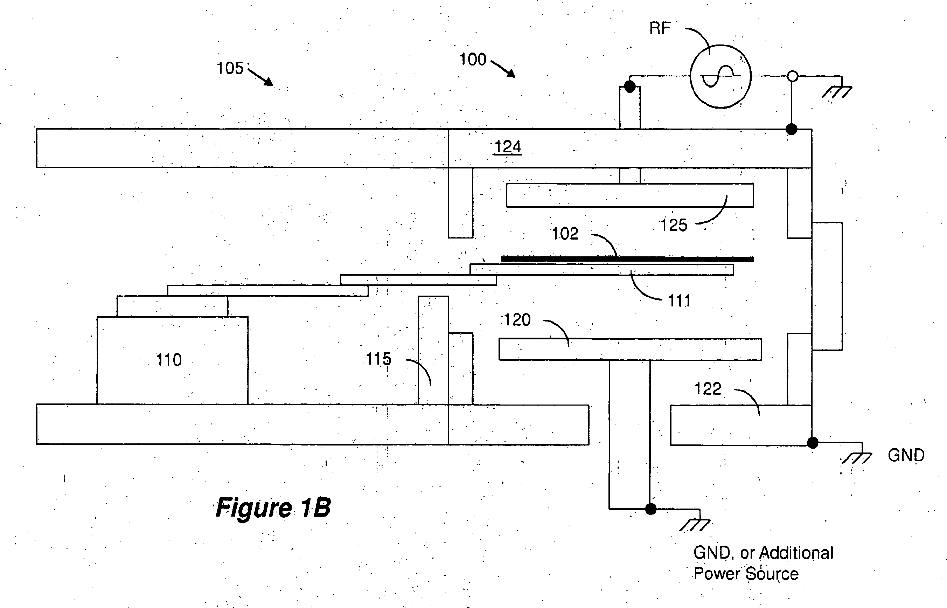

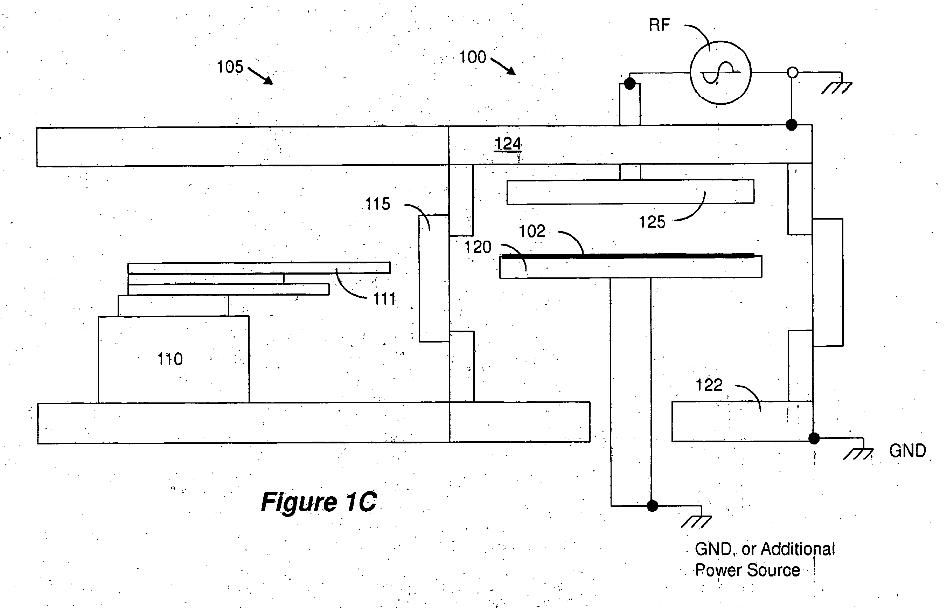

In Fig. 1B, the vacuum door 115 has been opened, and the articulated arm 111 introduces the substrate into the interior of the processing chamber 100. In Fig. 1C, the substrate has been placed onto the susceptor 120, the articulated arm 111 has been retrieved, and the vacuum door 115 has been closed. In this condition plasma can be ignited and the processing can be carried out. Since the single substrate seats directly onto the susceptor, it generally conforms to irregularities on the susceptor and maintains good physical and uniform electrical contact with the susceptor.

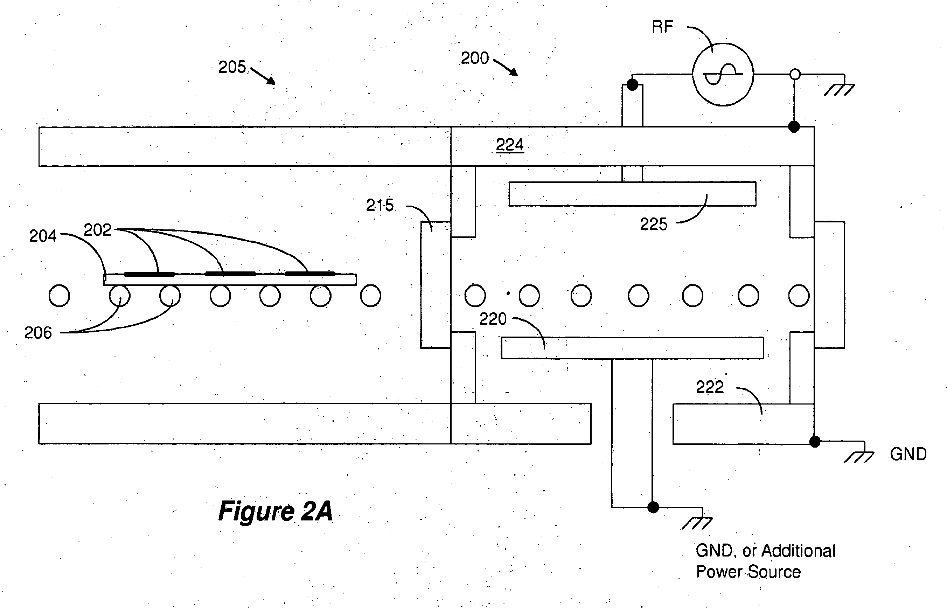

Figs. 2A-2D are schematics of various stages of a vacuum processing chamber for processing multiple substrate placed on a carrier, in which embodiments of the invention may be implemented. This embodiment is particularly suitable for fabricating solar cells on silicon wafers. It should be noted that while the illustrated embodiment shows a tray or carrier suitable for carrying several substrates simultaneously, the same can be done with a tray that is configured for carrying a single substrate. Loading chamber 205 is used to load several substrates 202, which are positioned on a tray 204, into vacuum processing chamber 200. In Fig. 2A, the vacuum door 215 is closed, and the substrates 202 are positioned on the tray 204, which may be delivered using rollers 206, endless belt, etc. As shown, the lower electrode 220, the chamber's body 222 and the chamber's ceiling 224 are all grounded. In this example, RF power is coupled to the upper electrode 225 while ground or other power is provided to the lower electrode 220. However, it is also known to couple ground to the upper electrode and supply RF power to the lower electrode or supply RF power to both the electrodes in a grounded chamber.

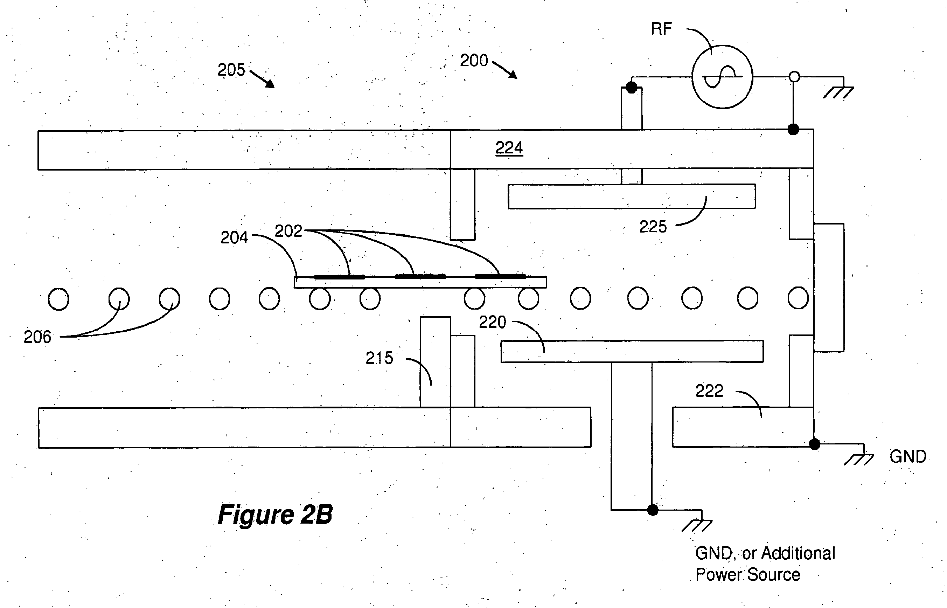

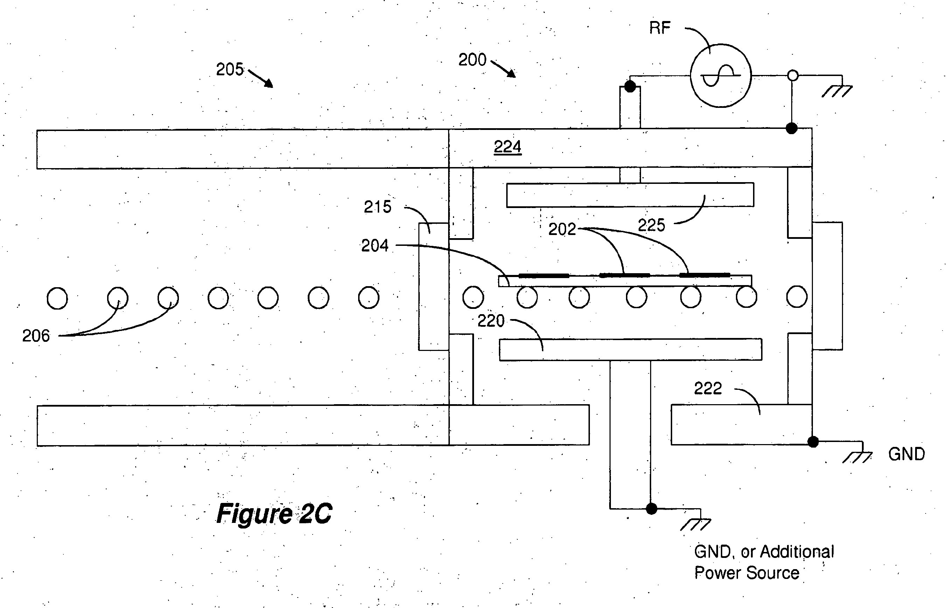

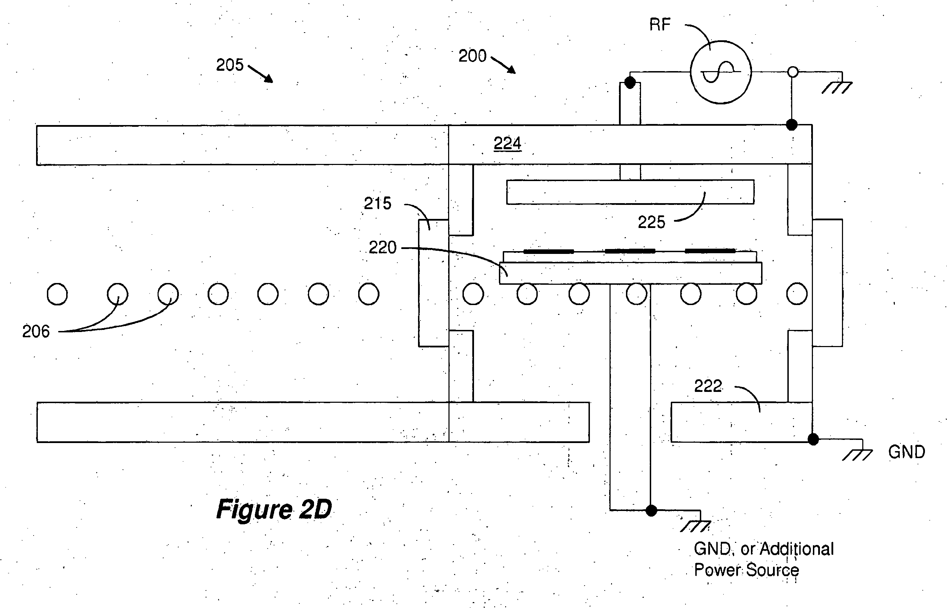

In Fig. 2B, the vacuum door 215 has been opened, and the tray 204 is introduced into the interior of the processing chamber 200. In Fig. 2C, vacuum door has been closed and vacuum can be drawn inside the chamber 200. In Fig. 2D the tray 204 been placed onto the susceptor 220, which has been raised into its processing position. In this condition plasma can be ignited and the processing can be carried out. Since the single substrates do not seat directly on the susceptor, but are rather placed on a tray, and since the tray does not generally conform to irregularities on the susceptor, no uniform electrical-contact is being made to the susceptor. That is, the electrical path must pass from the susceptor to the tray and from the tray to each of the wafers. The tray or carrier does not fully conform to the susceptor and, consequently, electrical contact is not uniform and is rather limited to discrete points.

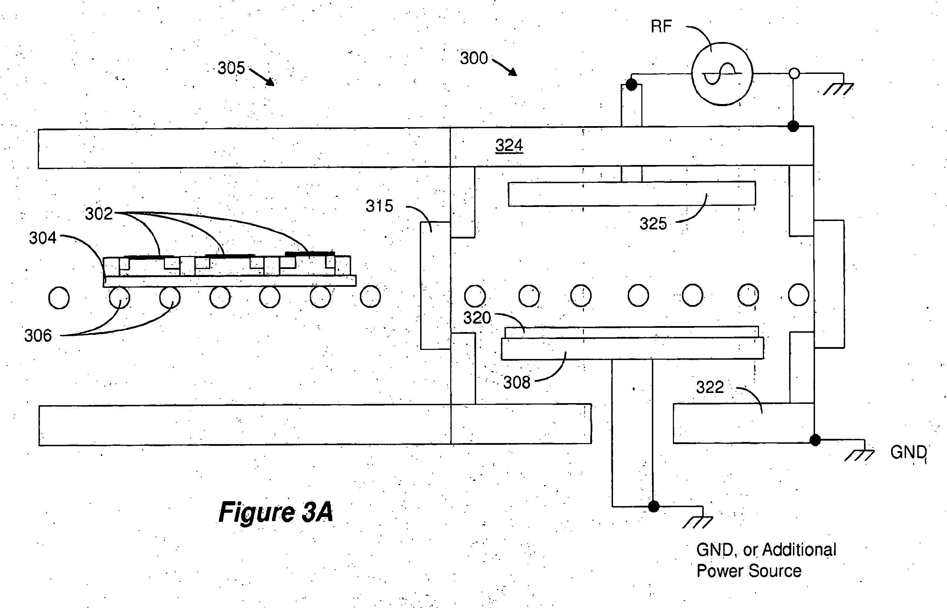

Figs. 3A-3F are schematics of various stages of a vacuum processing chamber for processing multiple substrate placed on a susceptor, in which embodiments of the invention may be implemented. This embodiment is particularly suitable for fabricating solar cells, LED's, etc., on silicon wafers. It should be noted that while the illustrated embodiment shows a tray or carrier suitable for carrying several substrates simultaneously, the same can be done with a tray or carrier that is configured for carrying a single substrate. Loading chamber 305 is used to load several substrates 302, which are positioned on a tray or carrier 304, into vacuum processing chamber 300. In Fig. 3A, the vacuum door 315 is closed, and the substrates 302 are positioned on the tray 304, which may be delivered using rollers 306, endless belt, etc. As shown, the lower electrode 320, the chamber's body 322 and the chamber's ceiling 324 are all grounded. In this example, RF power is coupled to the upper electrode 325 while ground or other power is provided to the lower electrode 320. In this embodiment the susceptor is seated on pedestal 308. However, it is also known to couple ground to the upper electrode and supply RF power to the tower electrode or supply RF power to both the electrodes in a grounded chamber.

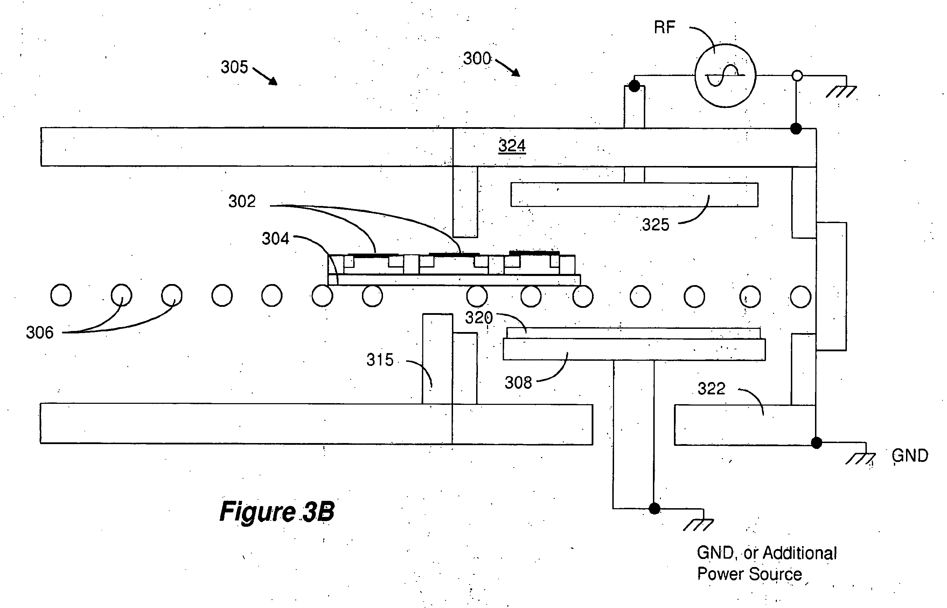

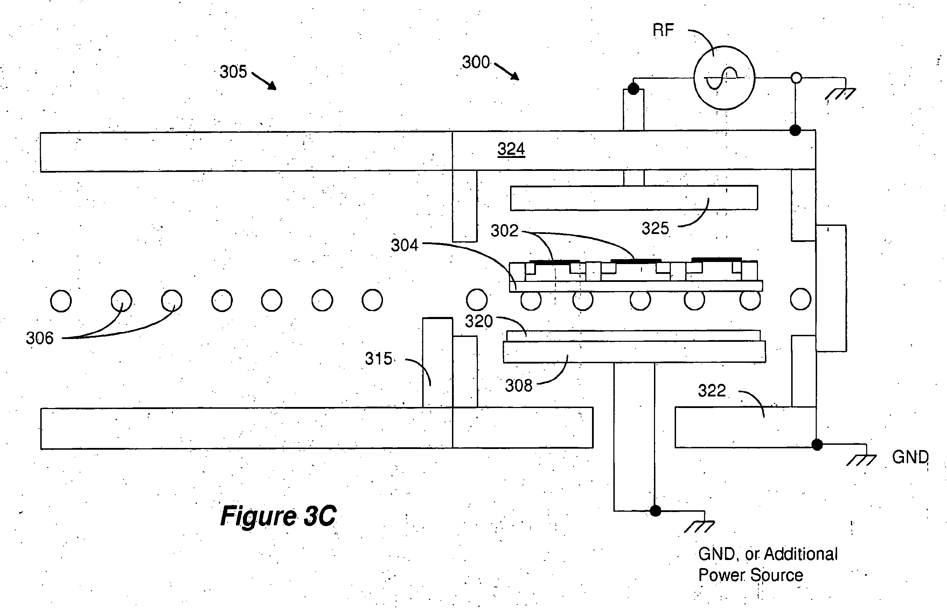

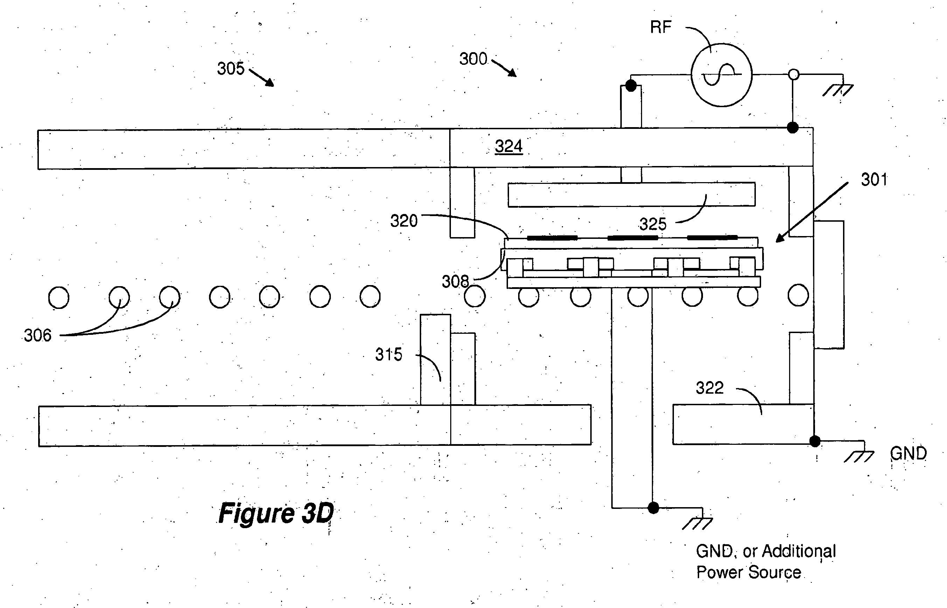

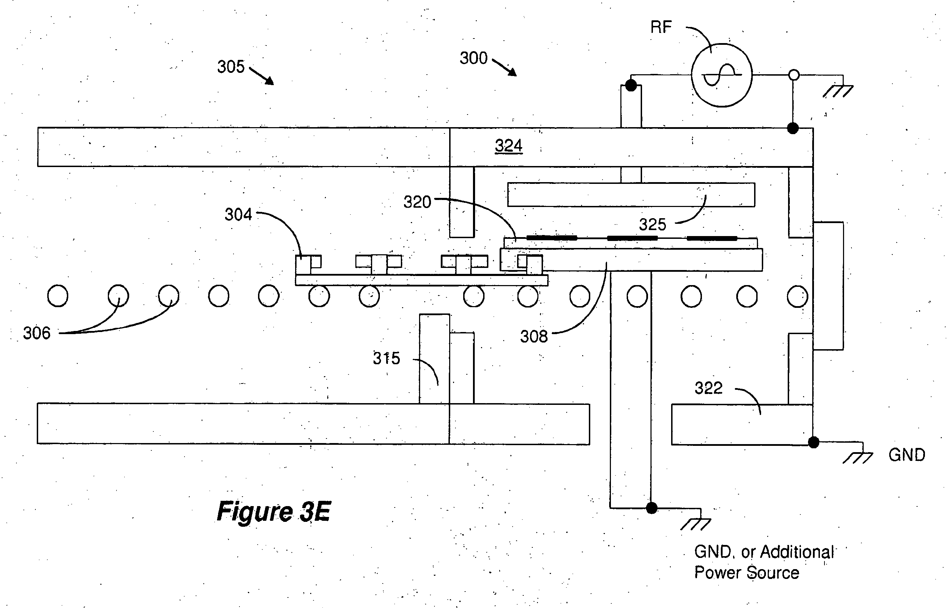

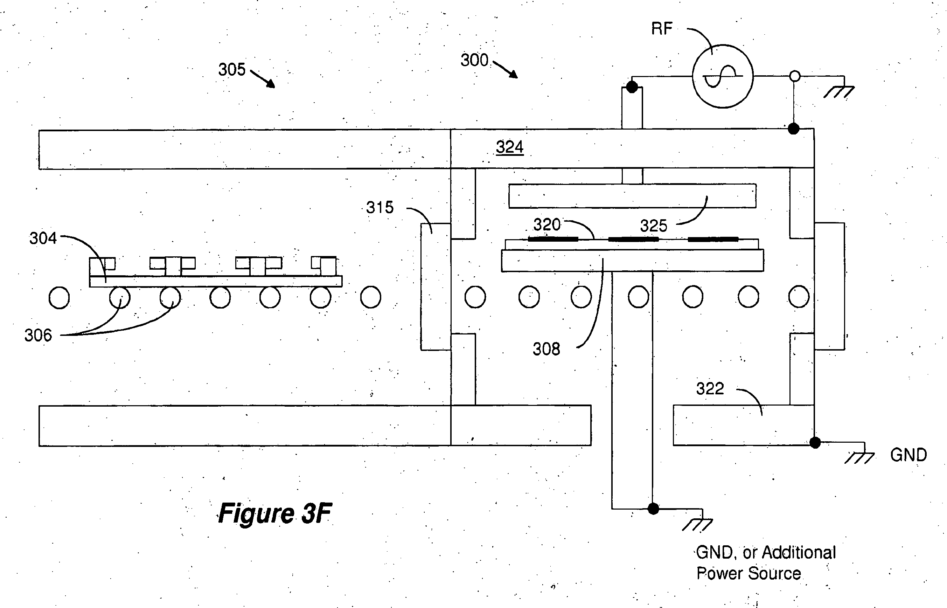

In Fig. 3B, the vacuum door 315 has been opened, and the tray 304 is introduced into the interior of the processing chamber 300. In Fig. 3C, the tray 304 is completely within the chamber 300. In Fig. 3D the susceptor is lifted and the substrates are transferred from the tray onto the susceptor. That is, the chamber of Figs. 3A-3F includes a transfer mechanism 301 that is configured to transfer substrates from the tray onto the susceptor. In Fig. 3E the tray 304 is removed from the chamber 300 and in Fig. 3F the vacuum door 315 been closed and vacuum can be drawn inside the chamber 300. In this condition, plasma can be ignited and the processing can be carried out. In this embodiment, the electrical path must pass from the pedestal to the susceptor, and from the susceptor to each of the wafers. However, since the susceptor and the pedestal are not perfectly flat, the susceptor does not fully conform to the pedestal and, consequently, electrical contact is not uniform and is rather limited to discrete points.

For providing a reliable and repeatable multi-point electrical contact to the carrier, the vacuum processing chamber or the invention comprises the features of claim 1. Preferred embodiments of the invention are characterized in the sub-claims.

A vacuum processing chambers having provisions for improved electrical contact to substrate carrier is disclosed. Specific embodiments provide a plasma processing chamber having a pedestal for supporting the carrier, and a plurality of fixed posts and resilient contacts are distributed over the area of the pedestal. The fixed posts provide physical support for the carrier, while the resilient contacts provide reliable and repeatable multi-point electrical contact to the carrier.

Further advantages, features and potential applications of the present invention may be gathered from the description which follows, in conjunction with the embodiments illustrated in the drawings.
- Figs. 1A-1C: are schematics of various stages of a vacuum processing chamber for processing one single substrate at a time, in which embodiments of the invention may be implemented.
- Figs. 2A-2D: are schematics of various stages of a vacuum processing chamber for processing multiple substrate placed on a carrier, in which embodiments of the invention may be implemented.
- Figs. 3A-3F: are schematics of various stages of a vacuum processing chamber for processing multiple substrate placed on a susceptor, in which embodiments of the invention may be implemented.
- Figs 4A-4D: are schematics of vacuum processing chambers according to various embodiments of the invention.
- Fig. 4E: illustrates a top view of the chamber according to an embodiment of the invention.
- Fig. 4F: illustrates an alternative embodiment for the resilient contact.
- Fig. 4G: is a top view of another embodiment of the chamber according to the invention.

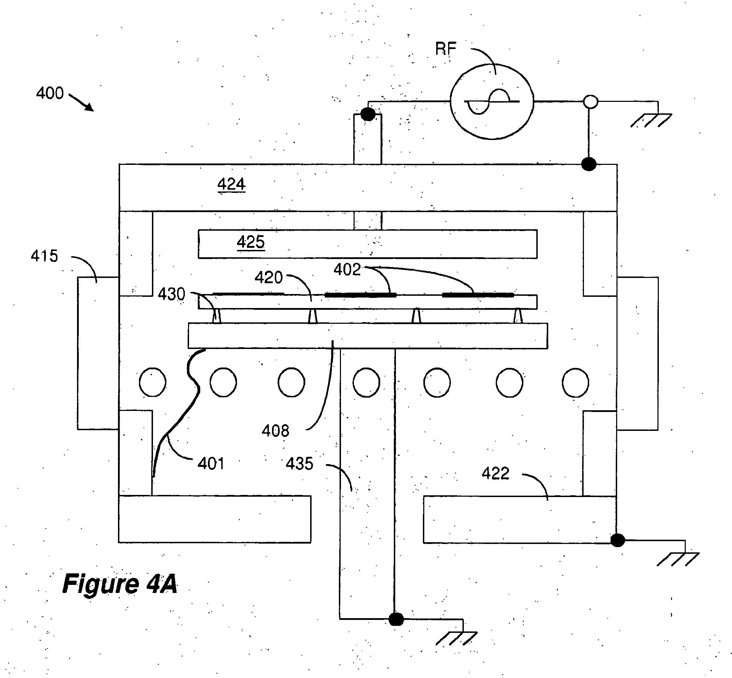

Fig. 4A is a schematic illustrating major elements of a plasma processing chamber 400 implementing an embodiment of the invention. The chamber 400 includes a chamber body 422 and a chamber's ceiling 424 generally made of metal, such as aluminum, stainless steel, etc. A pedestal 408 is provided for supporting a carrier 420, upon which one or more substrates 402 are positioned. Throughout the remaining of this description, the shorthand carrier will be used to refer to various alternative elements such as, a removable susceptor; a tray, a substrate holder, etc. The point here is that the substrates are placed on the carrier and the carrier is placed on the pedestal and needs to make electrical contact thereto. The pedestal 408 may be attached to a lift mechanism 435, so that it is lowered for substrates loading via the valve 415, and then lifted up to the illustrated position for processing. Grounding is provided to the pedestal through the lift mechanism 435 and/or via, e.g., conductive electrical band or strap 401, depending on the size of the susceptor and the amount of power that needs to be delivered to the susceptor.

At its top, the chamber has a cathode assembly 425 to which an RF power supply is coupled. In the illustrated configuration, ground potential is applied to the pedestal 408 so as to be coupled to the substrates. In order to avoid the grounding problems mentioned above, in this embodiment, fixed grounding posts 430 are affixed to the pedestal 408, which in this embodiment serves as an electrode grounded by conductive band 401. In this respect, it should be appreciated that although during operation the posts 430 are fixed in a position, the post are manually adjustable prior to operating the system in order to ensure edge contact and to cause the susceptor to conform to a desired profile. The carrier 420 is seated on the posts 430, such that electrical contact is made via the posts 430. The fixed posts 430 provide repeatable contact points for improved grounding. However, such an arrangement may have very few reliable points of contact with the carrier 420. This is especially the case when a tray is used, which is repeatedly removed and replaced inside the chamber. This is also the case for chambers where the susceptor is removable and is not bolted onto the pedestal.

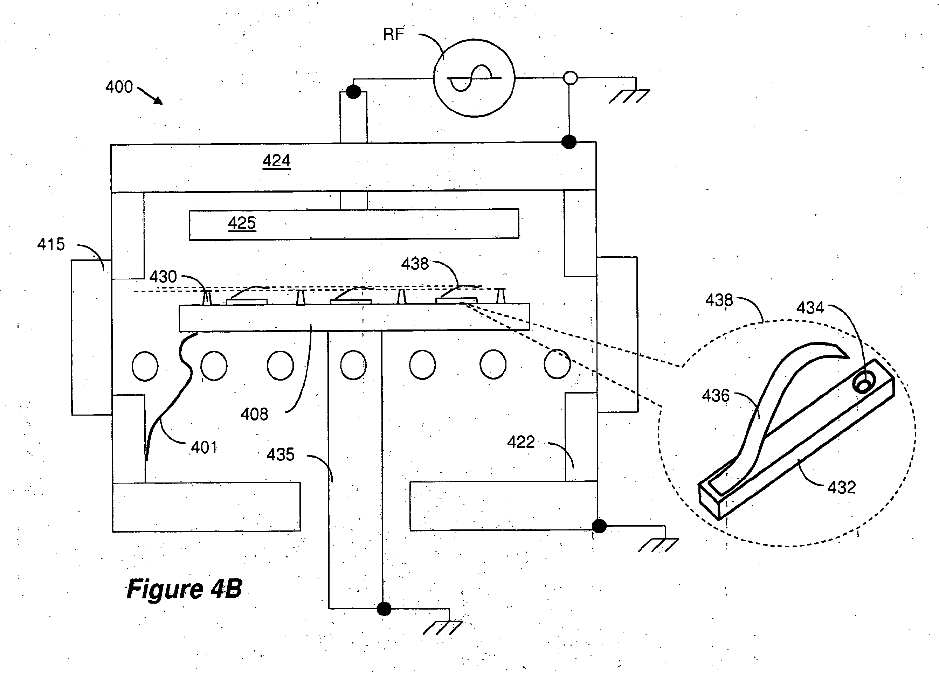

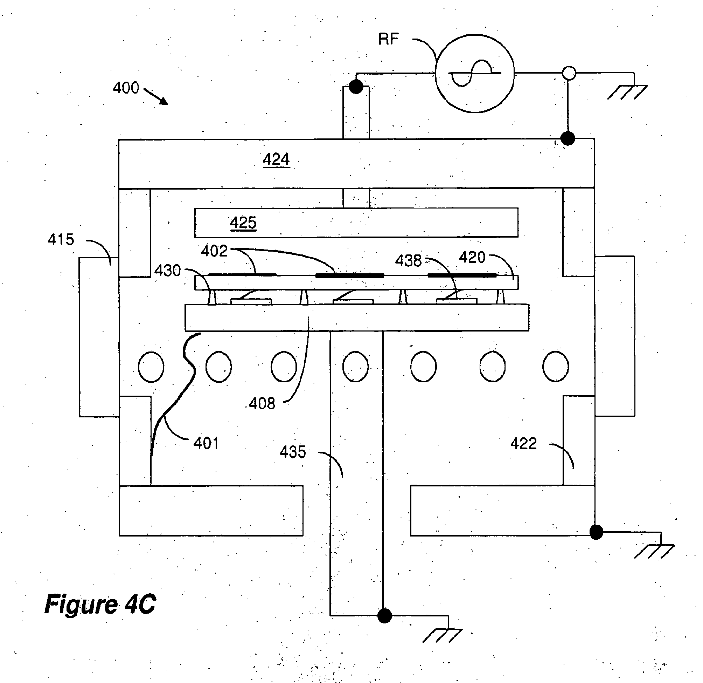

Fig. 4B illustrates another embodiment of the invention. The elements of Fig. 4B are similar to those of Fig. 4A, except that resilient grounding contacts 438 are added in addition to the fixed posts 430. As shown, when no tray or susceptor is placed on the pedestal, the top of the resilient grounding contacts 438 is extending above the top of the fixed posts 430. As shown in Fig. 4C, when a carrier 420 is placed on the pedestal 408, the carrier compresses the resilient contacts 438 until it rests on the posts 430. In this manner, good electrical contact is made through both the posts 430 and each of the resilient contacts 438. It should be appreciated however that in this embodiment the fixed posts 430 may or may not be conductive, since electrical contact is ensured via the resilient contacts 438. Also, either the posts 430 or the resilient contacts 438 may be affixed to the carrier 420, rather than to the pedestal 408.

The callout in Fig. 4B illustrates an example of a resilient contact 438. In this embodiment, a conductive spring 436, such as a leaf spring, is attached at one end to a conductive block 432. The block 432 is attached to the pedestal 408 by, e.g., bolt inserted through hole 434. When several resilient contacts 438 are secured to the pedestal 408, the conductive springs form loaded electrical contact to ensure repeatable, reliable and multi-point connection to the carrier, whether it be a tray, or susceptor, etc., as show in Fig. 4C. This arrangement facilitates repeatable removal and placement of a try with substrates on the pedestal, or removal and placement of a susceptor on the pedestal. For example, the susceptor can be removed for cleaning, service, disposing of broken substrate, etc. As shown in Fig. 4C, the weight of the carrier compresses the spring 436 until the carrier rests on the fixed posts 430.

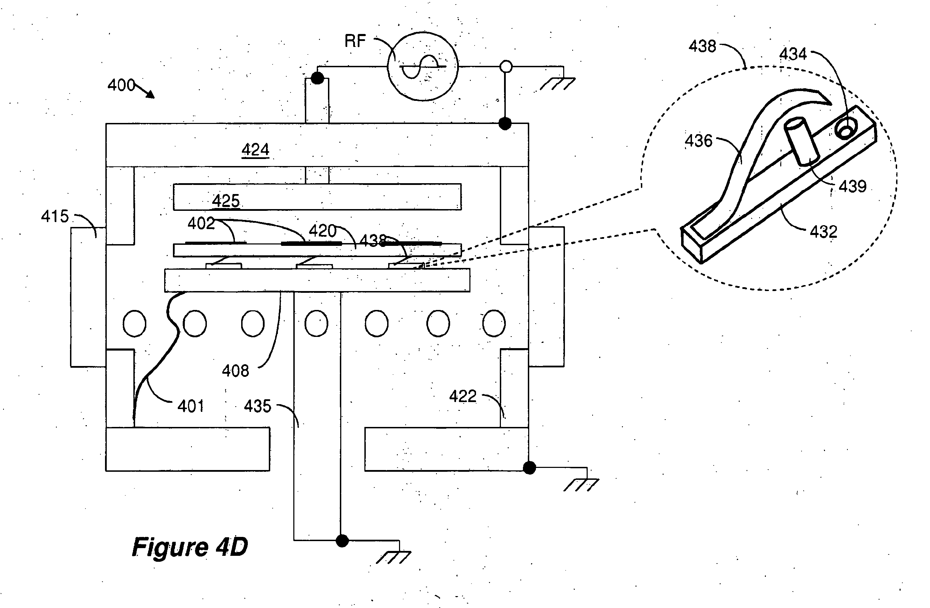

Fig. 4D illustrates an example where no separate fixed posts are provided. Instead, a plurality of resilient contacts 438 are affixed to the pedestal or the floor of the chamber, and the carrier 420 rests directly on the springs 436. This embodiment may employ the resilient contacts 438 as described with reference to Fig.s 4B and 4C. On the other hand, as shown in the callout of Fig. 4D, this embodiment may employ a modified resilient contact that includes a stop 439. As can be understood, the spring 436 may be compressed by the weight of the carrier until the spring 436 contacts the stop 439. This limits the amount of compression of spring 436 and thereby fixes the elevation of the carrier 420. According to one embodiment, the chamber is provided with resilient contacts 438, wherein some of the resilient contacts 438 include stops, and the rest do not include a stop. For example, only the contacts 438 which are placed at the corners have stops, and the rest do not. According to another embodiment, all of the resilient contacts include stops.

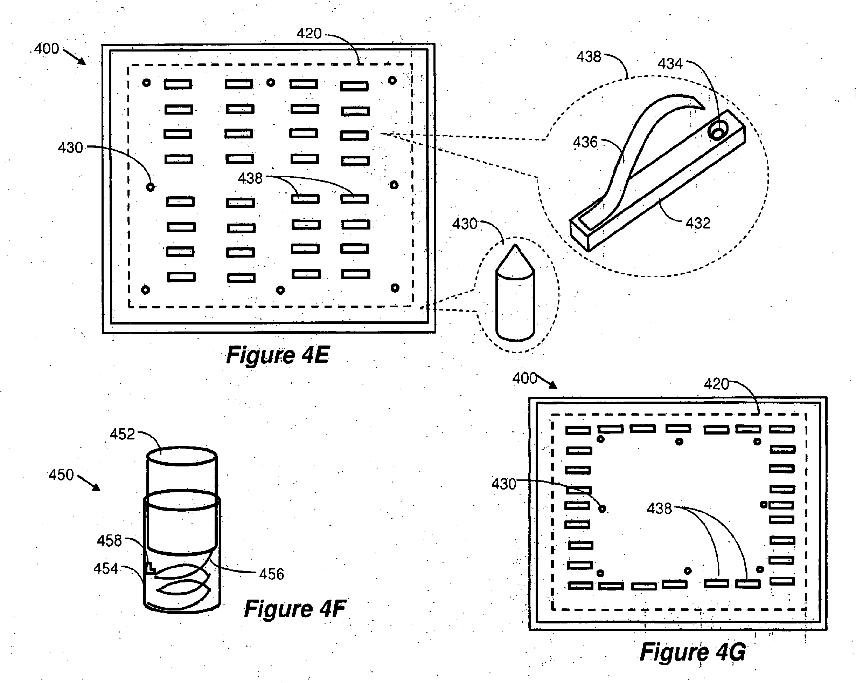

Fig. 4E illustrates a top view of the chamber 400, wherein the carrier 420 is illustrated in broken line to indicate that it has been removed from the chamber. As shown, a relatively small number of posts 430 are provided, generally at the periphery of the pedestal. Large number resilient contacts 438 are distributed evenly throughout the area of the pedestal. That is, the number of resilient contacts is larger than the number of fixed posts, so that the fixed posts provide reliable and repeatable physical orientation, while the resilient contacts provide a reliable, repeatable, and distributed electrical contact. When the carrier is placed in the chamber, it compresses the resilient contacts 438 to make good electrical contact, and then rests on the posts 430 that are on the periphery, thereby ensuring proper alignment. As shown in the callout, the posts 430 may include a conical top portion that may mate with a corresponding hole in the carrier to enhance the lateral and rotational alignment of the carrier.

Fig. 4F illustrates another embodiment of a resilient contact 450. In Fig. 4F, tubular section 454 is fixed, while sliding section 452 slides with respect to fixed section 454. In Fig. 4F, sliding section 452 is shown as having a smaller diameter and slide inside the fixed section 454, however it may be constructed such that it has a larger diameter and slide over the fixed section 454. A spring 456 urges the sliding section 452 to an extended position. When a carrier 420 is placed on the pedestal, the sliding section 452 slides down and makes good electrical contact to the carrier 420. According to one embodiment, optionally the resilient contact 450 includes a stop 458 that limits the compression of the sliding section 452. As explained before, using the stop option the fixed posts may be eliminated and instead several resilient contacts 450 with stops may be provided at the periphery or at the corners, while the remaining contacts may not have the stop.

Fig. 4G is a top view of another embodiment of the chamber 400, wherein the carrier 420 is illustrated in broken line to indicate that it has been removed from the chamber. As shown, a relatively small number of posts 430 are provided. Large number resilient contacts 438 are distributed evenly about the periphery of the pedestal. That is, the resilient contacts 438 are closer to the edge of the carrier 420 than the fixed posts, so that the current leaves the carrier 420 at the edge through the springs 436 and never get to the posts 430. The fixed posts provide reliable and repeatable physical orientation, while the resilient contacts provide a reliable, repeatable, and distributed electrical contact. When the carrier is placed in the chamber, it compresses the resilient contacts 438 to make good electrical contact, and then rests on the posts 430 that are on the periphery, thereby ensuring proper alignment. However, as discussed above and shown in Fig. 4D, one may eliminate the fixed posts and rely on resilient posts only, or on resilient posts with stops.

While the invention has been described with reference to particular embodiments thereof, it is not limited to those embodiments. Specifically, various variations and modifications may be implemented by those of ordinary skill in the art without departing from the invention's scope, as defined by the appended claims.

### List of reference signs

- 100: processing chamber
- 102: single substrate
- 105: loading chamber
- 110: robot
- 111: articulated arm
- 115: vacuum door
- 120: electrode, susceptor
- 122: chamber's body
- 124: chamber's ceiling
- 125: upper electrode
- 200: processing chamber
- 202: substrates
- 204: tray
- 205: loading chamber
- 206: rollers
- 215: vacuum door
- 220: electrode, susceptor
- 222: chamber's body
- 224: chamber's ceiling
- 225: electrode
- 300: processing chamber
- 301: transfer mechanism
- 302: substrates
- 304: tray
- 305: loading chamber
- 306: rollers
- 308: pedestal
- 315: vacuum door
- 320: electrode
- 322: chamber's body
- 324: chamber's ceiling
- 325: electrode
- 400: processing chamber
- 401: band, strap
- 402: substrates
- 408: pedestal
- 415: valve
- 420: carrier
- 422: chamber body
- 424: chamber's ceiling
- 425: cathode assembly
- 430: posts
- 432: block
- 434: hole
- 435: lift mechanism
- 436: spring
- 438: contacts
- 439: stop
- 450: contact
- 452: sliding section
- 454: fixed section
- 456: spring
- 458: stop

- RF: power

## Claims

1. A vacuum processing chamber, comprising:
a chamber body (422);
a pedestal (408) provided at a lower portion of the chamber body (422);
a plurality of contacts (438, 450) provided on a top surface of the pedestal (408);
a ground potential path coupling each of the contacts (438, 450) to ground potential;
**characterized in that**:
the contacts are resilient, and
a substrate carrier (420) is seated on the pedestal (408), compresses the contacts (438, 450) and is making electrical contact to the contacts (438, 450).

2. The vacuum processing chamber of claim 1, further **characterized by** a plurality of fixed posts (430) affixed to the top surface of the pedestal (408).

3. The vacuum processing chamber of claim 2, **characterized in that** the plurality of fixed posts (430) are provided at periphery area of the pedestal (408) and the plurality of resilient contacts (438, 450) are distributed evenly over the area of the pedestal (408).

4. The vacuum processing chamber of claim 1, **characterized in that** at least a portion of the plurality of resilient contacts (438, 450) comprises a stop (439, 458).

5. The vacuum processing chamber of claim 1, **characterized in that** the plurality of resilient contacts (438, 450) are distributed about the periphery of the pedestal (408) and that the resilient contacts (438, 450) that are positioned at corners comprise stops (439, 458).

6. The vacuum processing chamber of claim 1, **characterized in that** each of the resilient contacts (438) comprises a conductive block (432) and a leaf spring (436) attached at one end thereof to the conductive block (432).

7. The vacuum processing chamber of claim 6, **characterized in that** each of the resilient contacts (438) further comprises a stop (439) provided between the conductive block (432) and the leaf spring (436).

8. The vacuum processing chamber of claim 1, **characterized in that** each of the resilient contacts (450) comprises a fixed part (454) and a sliding part (452), and a spring (456) urging the sliding part (452) to an extended position.

9. The vacuum processing chamber of any of claims 1 to 8, **characterized in that** the substrate carrier (420) comprises a susceptor configured for supporting a plurality of substrates simultaneously.

10. The vacuum processing chamber of any of the claims 1 to 8, **characterized in that** the substrate carrier (420) comprises a substrate tray which is preferably configured for supporting a plurality of substrates.

11. The vacuum processing chamber of any of the claims 1 to 12, **characterized in that** the substrate carrier (420) comprises one of a removable susceptor or a tray.

12. The vacuum processing chamber of claim 11, further **characterized by** a transfer mechanism configured to transfer substrates from a tray onto the susceptor.

13. The vacuum processing chamber for simultaneous plasma processing of a plurality of substrates positioned on a carrier (420) according to any of the claims 1 to 12, **characterized by** a showerhead provided at upper section of the chamber body (422).

14. The vacuum processing chamber of any of the claims 1 to 13, **characterized in that** the plurality of resilient contacts (438, 450) are provided at a periphery area of the substrate carrier (420) and further comprising a plurality of fixed posts (430) on the top surface of the pedestal (408).

## Patentansprüche

1. Vakuumsverarbeitungskammer umfassend:
einen Kammerkörper (422);
ein Podest (408), das an einem unteren Abschnitt des Kammerkörpers (422) vorgesehen ist;
eine Vielzahl von Kontakten (438, 450), die auf einer Oberfläche des Podests (408) vorgesehen sind;
einen Erdpotenzialpfad, der jeden der Kontakte (438, 450) mit Erdpotenzial koppelt;
**dadurch gekennzeichnet, dass**
die Kontakte federnd nachgiebig sind, und
ein Substratträger (420) auf dem Podest (408) aufgesetzt ist, die federnd nachgiebigen Kontakte (4 13 8,450) komprimiert und einen elektrischen Kontakt mit den federnd nachgiebigen Kontakten (43 8,450) herstellt.

2. Vakuumsverarbeitungskammer nach Anspruch 1, ferner **gekennzeichnet durch** eine Vielzahl von feststehenden Pfosten (430), die an der oberen Fläche des Podests (408) befestigt sind.

3. Vakuumsverarbeitungskammer nach Anspruch 2, **dadurch gekennzeichnet, dass** die Vielzahl von feststehenden Pfosten (430) an einem peripheren Bereich des Podests (408) vorgesehen sind, und dass die Vielzahl der federnd nachgiebigen Kontakte (438,450) gleichmäßig über den Bereich des Podests (408) verteilt sind.

4. Vakuumsverarbeitungskammer nach Anspruch 1, **dadurch gekennzeichnet, dass** wenigstens ein Teil der Vielzahl der federnd nachgiebigen Kontakte (438, 450) einen Anschlag (439, 458) aufweist.

5. Vakuumsverarbeitungskammer nach Anspruch 1, **dadurch gekennzeichnet, dass** die Vielzahl der federnd nachgiebigen Kontakte (438, 450) um die Peripherie des Podests (408) herum verteilt sind, und dass die federnd nachgiebigen Kontakte (438, 450), die an den Ecken positioniert sind, Anschläge (43 9,458) aufweisen.

6. Vakuumsverarbeitungskammer nach Anspruch 1, **dadurch gekennzeichnet, dass** jeder der federnd nachgiebigen Kontakte (438) einen leitfähigen Block (432) und eine Blattfeder (436) aufweist, die an einem Ende davon an dem leitfähigen Block (432) befestigt ist.

7. Vakuumsverarbeitungskammer nach Anspruch 6, **dadurch gekennzeichnet, dass** jeder der federnd nachgiebigen Kontakte (438) ferner einen Anschlag (439) aufweist, der zwischen dem leitfähigen Block (432) und der Blattfeder (436) vorgesehen ist.

8. Vakuumsverarbeitungskammer nach Anspruch 1, **dadurch gekennzeichnet, dass** jeder der federnd nachgiebigen Kontakte (540) einen fixierten Teil (454) und einen gleitenden Teil (452) umfasst, sowie eine Feder (456), die den gleitenden Teil (452) in eine ausgefahrene Position drückt.

9. Vakuumsverarbeitungskammer nach einem der Ansprüche 1 bis 8, **dadurch gekennzeichnet, dass** der Substratträger (420) einen Suszeptor aufweist, der konfiguriert ist, um eine Vielzahl von Substraten gleichzeitig tragen.

10. Vakuumsverarbeitungskammer nach einem der Ansprüche 1 bis 8, **dadurch gekennzeichnet, dass** der Substratträger (420) ein Substrattablett umfasst, welches vorzugsweise konfiguriert ist, um eine Vielzahl von Substraten zu tragen.

11. Vakuumsverarbeitungskammer nach einem der Ansprüche 1 bis 10, **dadurch gekennzeichnet, dass** der Substratträger (420) einen abnehmbaren Suszeptor oder ein Tablett umfasst.

12. Vakuumsverarbeitungskammer nach Anspruch 11, ferner **gekennzeichnet durch** eine Transfereinrichtung, die konfiguriert ist, um Substrate von einem Tablett auf den Suszeptor zu transferieren.

13. Vakuumsverarbeitungskammer zur gleichzeitigen Plasmaverarbeitung einer Vielzahl von Substraten, die auf einem Träger (420) positioniert sind, entsprechend einem der Ansprüche 1 bis 12, **gekennzeichnet durch** einen Duschkopf, der an einem oberen Abschnitt des Kammerkörpers (422) vorgesehen ist.

14. Vakuumsverarbeitungskammer nach einem der Ansprüche 1 bis 13, **dadurch gekennzeichnet, dass** die Vielzahl der federnd nachgiebigen Kontakte (438, 450) an einem peripheren Bereich des Substratträgers (420) vorgesehen ist, und ferner umfassend eine Vielzahl von feststehenden Pfosten (430) auf der oberen Fläche des Podests.

## Revendications

1. Chambre de traitement sous vide, comprenant:
- un corps de la chambre (422);
- un piédestal (408) pourvu à une partie inférieure du corps de chambre (422);
- une pluralité de contacts (438, 450) pourvus sur une surface supérieure du piédestal (408);
- une voie de potentiel de la terre couplant chacun des contacts (438, 450) au potentiel de la terre;
**caractérisée en ce que**
- les contacts sont résilients, et
- un support de substrat (420) est fixé sur le piédestal (408), fait comprimer les contacts résilients (438, 450) et fait un contact électrique aux contacts résilients (438, 450).

2. Chambre de traitement sous vide selon la revendication 1, **caractérisée de plus par** une pluralité d'appuis invariables (430) fixés à la surface supérieure du piédestal (408).

3. Chambre de traitement sous vide selon la revendication 2, **caractérisée en ce que** la pluralité d'appuis invariables (430) sont pourvus à la zone périphérique du piédestal (408) et la pluralité de contacts résilients (438, 450) sont distribués uniformément sur la surface du piédestal (408).

4. Chambre de traitement sous vide selon la revendication 1, **caractérisée en ce qu'**au moins une portion de la pluralité de contacts résilients (438, 450) comprend un arrêt (439, 458).

5. Chambre de traitement sous vide selon la revendication 1, **caractérisée en ce que** la pluralité de contacts résilients (438, 450) sont distribués autour la périphérie du piédestal (408) et que les contacts résilients (438, 450) qui sont positionnés aux coins comprennent les arrêts (439, 458).

6. Chambre de traitement sous vide selon la revendication 1, **caractérisée en ce que** chacun des contacts résilients (438,450) comprend un bloc conducteur (432) et un ressort à lames (436) attaché à une extrémité au bloc conducteur (432).

7. Chambre de traitement sous vide selon la revendication 6, **caractérisée en ce que** chacun des contacts résilients (438) comprend de plus un arrêt (439) pourvu entre le bloc conducteur (432) et le ressort à lames (436).

8. Chambre de traitement sous vide selon la revendication 1, **caractérisée en ce que** chacun des contacts résilients (438) comprend une partie fixe (454) et une partie glissante (452), et un ressort (456) poussant la partie glissante (452) vers une position d'extension.

9. Chambre de traitement sous vide selon l'une quelconque des revendications 1 à 8, **caractérisée en ce que** le support de substrat (420) comprend un suscepteur configuré pour soutenir simultanément une pluralité de substrats.

10. Chambre de traitement sous vide selon l'une quelconque des revendications 1 à 8, **caractérisée en ce que** le support de substrat (420) comprend un plateau de substrat qui est configuré préférablement pour soutenir une pluralité de substrats.

11. Chambre de traitement sous vide selon l'une quelconque des revendications 1 à 10, **caractérisée en ce que** le support de substrat (420) comprend l'un d'entre un suscepteur éloignable ou un plateau.

12. Chambre de traitement sous vide selon la revendication 11, **caractérisée de plus par** un mécanisme de transfert configuré pour transférer les substrats d'un plateau sur le suscepteur.

13. Chambre de traitement sous vide pour traiter simultanément le plasma d'une pluralité de substrats positionnés sur un support (420) selon l'une quelconque des revendications 1 à 12, **caractérisée par** une douche pourvue à la section supérieure du corps de chambre (422).

14. Chambre de traitement sous vide selon l'une quelconque des revendications 1 à 13, **caractérisée en ce que** la pluralité de contacts résilients (438, 450) sont pourvus à la zone périphérique du support de substrat (420) et comprenant de plus une pluralité d'appuis invariables (430) sur la surface supérieure du piédestal (408).
